# EUROPEAN PATENT APPLICATION

(11) **EP 4 804 392 A1**
(43) Date of publication of application: **09.09.2026**
(21) Application number: 24884597.6
(22) Date of filing: 25.10.2024
(51) Int. Cl.: H02M 1/00, H05K 9/00, H05K 7/20

(54) **POWER MODULE AND POWER DEVICE**

(30) Priority: 03.11.2023 CN 202311458870
(71) Applicant: Hoymiles Power Electronics Inc., Hangzhou, Zhejiang 310015 (CN)
(72) Inventor: YU, Hongbin, Hangzhou, Zhejiang 310015 (CN); JIE, Donghua, Hangzhou, Zhejiang 310015 (CN); SHI, Keyan, Hangzhou, Zhejiang 310015 (CN); CAO, Yong, Hangzhou, Zhejiang 310015 (CN); ZHAO, Yi, Hangzhou, Zhejiang 310015 (CN); YANG, Bo, Hangzhou, Zhejiang 310015 (CN)
(74) Representative: Petraz, Gilberto Luigi
(86) International application number: PCT/CN2024/127355
(87) International publication number: WO 2025/092594

(57) **Abstract**

A power module and a power device are provided. The power module includes: a circuit board including an upper surface layer and a lower surface layer; at least one switch circuit arranged on the upper surface layer of the circuit board, the switch circuit including a first switch unit, a second switch unit, and a first capacitor unit, and the first switch unit, the second switch unit, and the first capacitor unit are electrically connected to form a commutation loop which is located on the upper surface layer or passes through the upper surface layer; and a metal plate arranged above the first switch unit, the second switch unit, and the first capacitor unit.

## Description

### CROSS-REFERENCE TO RELATED APPLICATION

This application claims priority to Chinese patent application No. 202311458870.9, filed on November 3, 2023, titled "POWER MODULE AND POWER DEVICE". The content of the above identified application is hereby incorporated herein in its entirety by reference.

### TECHNICAL FIELD

The present invention generally relates to the field of power devices, and in particular, to a power module and a power device.

### BACKGROUND

Light weight, miniaturization, high frequency, and high efficiency and high power density are development trends of an electronic power module. Increasing a switching frequency of the electronic power module can effectively reduce a size of a filter capacitor, a filter inductor, and a transformer, thereby effectively reducing a volume and a weight thereof, but the increase of the switching frequency will bring an increase in a loss of the electronic power module, which is a challenge for heat dissipation, and one direction to solve the heat dissipation is to increase a switching speed and reduce a switching loss from the source, but the increase of the switching speed brings a new problem that the electromagnetic interference (EMI) is more serious.

In the related art, it is difficult to achieve a good balance among the increase of the switching frequency, EMI, and heat dissipation, so as to solve the problems of EMI and heat dissipation while realizing the lightweight, miniaturization, high frequency, and high efficiency and high power density of the electronic power module, especially when a housing is a plastic housing, since there is no conventional metal housing, a common mode noise cannot be filtered out by placing a Y capacitor, which makes it more difficult to solve the problems of EMI and heat dissipation.

### SUMMARY

According to various embodiments of the present invention, a power module and a power device are provided.

In a first aspect, a power module is provided in an embodiment of the present invention, including a circuit board, at least one switch circuit, and a metal plate. The circuit board includes an upper surface layer and a lower surface layer. The at least one switch circuit is arranged on the upper surface layer of the circuit board, the at least one switch circuit includes a first switch unit, a second switch unit, and a first capacitor unit, and the first switch unit, the second switch unit, and the first capacitor unit are electrically connected to form a commutation loop which is located on the upper surface layer of the circuit board or passes through the upper surface layer of the circuit board. The metal plate is arranged above the first switch unit, the second switch unit, and the first capacitor unit.

In an embodiment, the first capacitor unit is disposed on a same side of the first switch unit and the second switch unit, or disposed between the first switch unit and the second switch unit.

In an embodiment, the circuit board further includes at least one inner layer between the upper surface layer of the circuit board and the lower surface layer of the circuit board, a first through hole and a second through hole are defined on the upper surface layer of the circuit board, and both the first through hole and the second through hole extend to and are electrically connected to the at least one inner layer of the circuit board. The first through hole and the second through hole are electrically connected to the first capacitor unit and the second switch unit, respectively, a first electrical connection path between the first switch unit and the first capacitor unit and between the first switch unit and the second switch unit is disposed on the upper surface layer of the circuit board, and a second electrical connection path between the first capacitor unit and the second switch unit passes through the first through hole, the at least one inner layer of the circuit board, and the second through hole; or the first through hole and the second through hole are electrically connected to the first switch unit and the second switch unit, respectively, a first electrical connection path between the first capacitor unit and the first switch unit and between the first capacitor unit and the second switch unit is disposed on the upper surface layer of the circuit board, and a second electrical connection path between the first switch unit and the second switch unit passes through the first through hole, the at least one inner layer of the circuit board, and the second through hole. The commutation loop is defined by the first electrical connection path and the second electrical connection path.

In an embodiment, the second electrical connection path is located directly below the first electrical connection path.

In an embodiment, the second electrical connection path passes through one of the at least one inner layer of the circuit board closest to the upper surface layer of the circuit board.

In an embodiment, a metal layer is laid on an upper surface of one of the at least one inner layer of the circuit board closest to the upper surface layer of the circuit board at positions corresponding to the first switch unit, the second switch unit, and the first capacitor unit.

In an embodiment, the power module includes two switch circuits, the two switch circuits are arranged side by side or along a straight line, and current directions of commutation loops corresponding to the two switch circuits are opposite.

In an embodiment, the power module further includes a plurality of second capacitor units disposed on the circuit board, an input port and an output port of the power module are electrically connected to the metal plate via corresponding second capacitor units, respectively, and the metal plate serves as a virtual ground.

In an embodiment, the metal plate is fixedly connected to the circuit board through at least one metal connector.

In an embodiment, the switch circuit further includes a third capacitor unit disposed on the upper surface layer or the lower surface layer of the circuit board and connected in parallel to the first capacitor unit, the third capacitor unit is connected to the first capacitor unit through either or both of metal wiring of the upper surface layer and a third through hole penetrating through the circuit board, and a capacitance value of the third capacitor unit is greater than that of the first capacitor unit.

In an embodiment, each of the first switch unit and the second switch unit includes at least one switch transistor.

In an embodiment, the first capacitor unit includes at least one capacitor.

In an embodiment, an electrically insulating and thermally conductive medium is filled between the circuit board and the metal plate.

In an embodiment, the switching circuit is a part of a Direct Current (DC)-Direct Current converter or a Direct Current-Alternating Current (AC) converter.

In a second aspect, a power device is provided in the present invention, including the power module in the first aspect.

In an embodiment, the power device further includes a plastic housing within which the power module is located.

In an embodiment, the power device includes a power optimizer or an inverter.

Details of one or more embodiments of the present invention are proposed in the following accompanying drawings and descriptions, so that other features, objects, and advantages of the present invention are more easily understood.

### BRIEF DESCRIPTION OF THE DRAWINGS

To describe the technical solutions in the embodiments of the present invention or the related technologies more clearly, the following briefly describes the accompanying drawings required for describing the embodiments or the related technologies. Apparently, the accompanying drawings in the following description show merely the embodiments of the present invention, and one skilled in the art may still derive other drawings from the disclosed accompanying drawings without creative efforts.
FIG. 1 is a schematic circuit diagram of a switch circuit in an embodiment of the present invention.
FIG. 2 is a schematic cross-sectional view of a power module in a first embodiment of the present invention.
FIG. 3 is a schematic cross-sectional view of a power module in a second embodiment of the present invention.
FIG. 4 is a schematic cross-sectional view of a power module in a third embodiment of the present invention.
FIG. 5 is a schematic top view of the power module in the third embodiment of the present invention.
FIG. 6 is a schematic cross-sectional view of a power module in a fourth embodiment of the present invention.
FIG. 7 is a schematic top view of a power module in a fifth embodiment of the present invention.
FIG. 8 is a schematic diagram of a commutation loop of the power module in the fifth embodiment of the present invention.
FIG. 9 is a schematic topology diagram of a main circuit of a DC-DC converter in the present invention.
FIG. 10 is a schematic cross-sectional view of a power module in a sixth embodiment of the present invention.
FIG. 11 is a schematic bottom view of a power module in a seventh embodiment of the present invention.
FIG. 12 is a schematic topology diagram of a main circuit of a DC-AC converter in the present invention.
FIG. 13 is a schematic cross-sectional view of a power module in an eighth embodiment of the present invention.

### DETAILED DESCRIPTION OF THE EMBODIMENT

To make objectives, technical solutions, and advantages of the present invention clearer, the following describes and explicates the present invention with reference to the accompanying drawings and embodiments. It should be understood that the specific embodiments described herein are only used to explain the present invention and are not intended to limit the present invention. All other embodiments obtained by one skilled in the art based on the embodiments provided in the present invention without creative efforts shall fall within the protection scope of the present invention. In addition, it can also be understood that although the efforts made in this development process may be complex and lengthy, for one skilled in the art related to the content disclosed in the present invention, some design, manufacturing or production changes made on the basis of the technical content disclosed in the present invention are conventional technical means, and should not be understood as insufficient content disclosed in the present invention.

The reference to "embodiments" in the present invention means that specific features, structures, or characteristics described in conjunction with the embodiments may be included in at least one embodiment of the present invention. A phrase appearing in various positions in the description does not necessarily refer to the same embodiment, nor is it an independent or alternative embodiment that is mutually exclusive with other embodiments. One skilled in the art will explicitly and implicitly understand that the embodiments described in the present invention can be combined with other embodiments without conflict.

Unless otherwise defined, the technical or scientific terms referred to in the present invention shall have the usual meanings understood by one skilled in the art to which the present invention belongs. Words in the present invention such as "one", "a", "a kind of", and/or "the" do not specifically refer to singular, but may also include plural. The terms "include", "contain", "have" and any variations thereof referred to in the present invention are intended to cover non-exclusive inclusions. For example, a process, a method, a system, a product, or an apparatus that includes a series of steps or modules (units) is not limited to the listed steps or units, but may also include steps or units that are not listed, or may also include other steps or units inherent to the process, the method, the system, the product, or the apparatus. The terms "junction", "connection", "coupling" and similar terms referred to in the present invention are not limited to physical or mechanical connections, but may include electrical connections, whether direct or indirect. The term "a plurality of" referred to in the present invention means greater than or equal to two. "And/or" describes an association relationship of associated objects, indicating that there can be three types of relationships. For example, "A and/or B" can represent: A exists alone, A and B exist simultaneously, and B exists alone. The terms "first", "second", "third", etc. mentioned in the present invention are only used to distinguish similar objects and do not represent a specific ranking for the objects.

A power module is provided in an embodiment of the present invention, including a circuit board, at least one switch circuit, and a metal plate. The circuit board includes an upper surface layer and a lower surface layer. The at least one switch circuit is arranged on the upper surface layer of the circuit board, the at least one switch circuit includes a first switch unit, a second switch unit, and a first capacitor unit, and the first switch unit, the second switch unit, and the first capacitor unit are electrically connected to form a commutation loop which is located on the upper surface layer or passes through the upper surface layer. The metal plate is arranged above the first switch unit, the second switch unit, and the first capacitor unit.

In the present embodiment, a smaller parasitic inductance and a smaller commutation loop can be achieved by closely arranging the first switch unit, the second switch unit, and the first capacitor unit in the power module and optimizing the layout of the formed commutation loop. On the one hand, a smaller parasitic inductance can achieve a higher switching frequency, and realize lightweight, miniaturization, high frequency, and high efficiency and high power density of the power module. On the other hand, a smaller commutation loop can reduce EMI from the source. By arranging the metal plate above the circuit board, the metal plate has an electromagnetic shielding function of preventing electromagnetic interference, and can conduct the heat on the circuit board to the entire metal plate, and then transfer the heat out in other ways, so that both the EMI problem caused by increasing the switching frequency and the heat dissipation problem can be solved at the same time. Therefore, the present invention not only realize lightweight, miniaturization, high frequency, and high efficiency and high power density of the power module, but also solve the EMI problem caused by increasing the switching frequency and the heat dissipation problem at the same time.

The switch circuit may be a part of a DC-DC converter or a DC-AC converter.

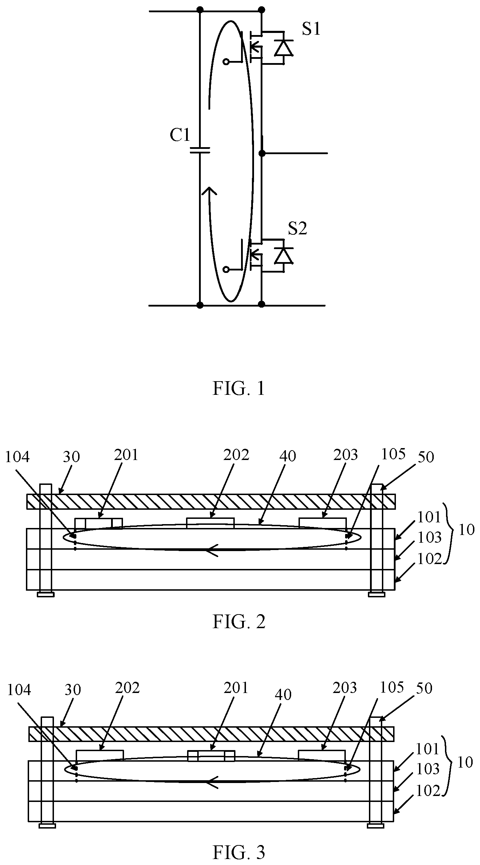

Each of the first switch unit and the second switch unit may include at least one switch transistor, and the first capacitor unit may include at least one capacitor. FIG. 1 is a schematic circuit diagram of a switch circuit in an embodiment of the present invention, in the switch circuit, the first switch unit may include a switch transistor S1, the second switch unit may include a switch transistor S2, and the first capacitor unit may include a capacitor C1.

In the following embodiments of the present invention, it is taken as an example for description that each of the first switch unit and the second switch unit includes one switch transistor and the first capacitor unit includes at least one capacitor.

FIG. 2 is a schematic cross-sectional view of a power module in a first embodiment of the present invention. In the present embodiment, the circuit board 10 may include an upper surface layer 101, a lower surface layer 102, and at least one inner layer 103 disposed between the upper surface layer 101 and the lower surface layer 102. A first switch unit 202 (corresponding to the switch transistor S1 in FIG. 1), a second switch unit 203 (corresponding to the switch transistor S2 in FIG. 1), and a first capacitor unit 201 (corresponding to the capacitor C1 in FIG. 1) may be electrically connected to form a commutation loop 40 passing through the upper surface layer 101. A first through hole 104 and a second through hole 105 may be defined on the upper surface layer 101, and both the first through hole 104 and the second through hole 105 may extend to and be electrically connected to the at least one inner layer 103. The first capacitor unit 201 may be disposed on a same side of the first switch unit 202 and the second switch unit 203. The first through hole 104 and the second through hole 105 may be located below the first capacitor unit 201 and the second switch unit 203, respectively, and the first through hole 104 and the second through hole 105 may be electrically connected to the first capacitor unit 201 and the second switch unit 203, respectively. A first electrical connection path between the first switch unit 202 and the first capacitor unit 201 and between the first switch unit 202 and the second switch unit 203 may be disposed on the upper surface layer 101, a second electrical connection path between the first capacitor unit 201 and the second switch unit 203 may pass through the first through hole 104, the at least one inner layer 103, and the second through hole 105, and the commutation loop 40 may be defined by the first electrical connection path and the second electrical connection path.

Specifically, the first capacitor unit 201, the first switch unit 202, and the second switch unit 203 may be arranged on the upper surface layer 101 and be closely arranged in a straight line, the first capacitor unit 201, the first switch unit 202, and the second switch unit 203 may be connected in the upper surface layer 101 through metal wiring to form the first electrical connection path. The commutation loop 40 may start from a second terminal of the first capacitor unit 201 to a second terminal of the first switch unit 202 through a first terminal of the first switch unit 202, the second terminal of the first switch unit 202 may be simultaneously connected to a first terminal of the second switch unit 203, reach a second terminal of the second switch unit 203 through a first terminal of the second switch unit 203, then reach an inner layer 103 immediately adjacent to the upper surface layer 101 through the second through hole 105, and return from the inner layer 103 to a first terminal of the first capacitor unit 201 through the first through hole 104. In this case, the second electrical connection path may be located directly below the first electrical connection path.

The first through hole 104 and the second through hole 105 may penetrate the circuit board 10, or may be blind holes and not need to penetrate the circuit board 10.

The upper surface layer 101 and the at least one inner layer 103 may be made as thin as possible, and an area of the commutation loop may be reduced to the greatest extent. Meanwhile, the components may be arranged as closely as possible, the metal wiring may be short and wide, a parasitic inductance of the commutation loop may be reduced as much as possible, an electromagnetic radiation may be greatly reduced, and the EMI may be greatly improved.

Furthermore, a metal layer may be laid on an upper surface of an inner layer 103 closest to the upper surface layer 101 at positions corresponding to the first switch unit 202, the second switch unit 203, and the first capacitor unit 201, to form a conductor plane that can partially shield EMI.

The metal plate 30 is disposed above the first capacitor unit 201, the first switch unit 202, and the second switch unit 203, and may have an electromagnetic shielding function of preventing electromagnetic interference. Referring to FIG. 2, the metal plate 30 may be fixedly connected to the circuit board 10 through at least one metal connector 50. The metal connector 50 may be, e.g., a screw, corresponding threaded holes may be defined on the metal plate 30 and the circuit board 10 (the threaded holes may or may not penetrate the circuit board 10), the metal plate 30 may be fixedly connected to the circuit board 10 through a screw, and an area of the metal plate 30 may be adapted to that occupied by the switch circuit, or may be consistent with that of the circuit board 10. In some other embodiments, a pin may be disposed on the metal plate 30, and be connected to the circuit board 10 by welding.

A spacing (e.g., may be 1.3 mm to 1.7 mm) between the metal plate 30 and the upper surface layer 101 of the circuit board 10 may be as small as possible when functional insulation is met, to ensure that thermal resistance between the metal plate 30 and a heating element (e.g., the first switch unit 202 and the second switch unit 203) is reduced by the spacing as much as possible on a basis of meeting an insulation requirement. The middle between the metal plate 30 and the heating element may be filled with an insulating and thermally conductive medium, so that the heat emitted by the first switch unit 202 and the second switch unit 203 during operation may be conducted from the body to the metal plate 30 through the thermally conductive medium, and the heat on the metal plate 30 may be then transferred to the outside through other ways. The insulating and thermally conductive medium may be a thermally conductive pad, a thermally conductive gel, or an element providing an insulating distance such as an adhesive tape and other thermally conductive fillers.

It should be noted that the first capacitor unit 201 may also be disposed between the first switch unit 202 and the second switch unit 203. Referring to FIG. 3, the first through hole 104 and the second through hole 105 may be electrically connected to the first switch unit 202 and the second switch unit 203, respectively, and the first through hole 104 and the second through hole 105 may be located below the first switch unit 202 and the second switch unit 203, respectively. The first capacitor unit 201 may be connected to the first switch unit 202 and the second switch unit 203 on the upper surface layer 101 through metal wiring to form the first electrical connection path, the second electrical connection path between the first switch unit 202 and the second switch unit 203 passes through the first through hole 104, the at least one inner layer 103, and the second through hole 105, and the commutation loop 40 may be defined by the first electrical connection path and the second electrical connection path.

Specifically, the commutation loop 40 may start from a second terminal of the first capacitor unit 201 to a second terminal of the first switch unit 202 through a first terminal of the first switch unit 202, the second terminal of the first switch unit 202 may reach the inner layer 103 adjacent to the upper surface layer 101 through the first through hole 104, and the inner layer 103 may reach a first terminal of the second switch unit 203 through the second through hole 105, reach a second terminal of the second switch unit 203 through the first terminal of the second switch unit 203, and return to a first terminal of the first capacitor unit 201 through the second terminal of the second switch unit 203.

In order to ensure that the area of the commutation loop is as small as possible, in the present invention, two exemplary device layout modes that minimize the area of the commutation loop according to a type of a switch device in the switch unit: for the devices with two terminals (such as the source and the drain) of the switch device located on both sides of the package, a layout mode thereof may refer to FIG. 2 and FIG. 3, and the inner layer 103 adjacent to the devices may be taken as a backflow path; and for the devices with two terminals of the switch device located on one side of the package, for example, when the switch devices in the first switch unit 202 and the second switch unit 203 are GaN transistors, the first capacitor unit 201 may be arranged between the first switch unit 202 and the second switch unit 203, and the commutation loop may be located on the upper surface layer 101.

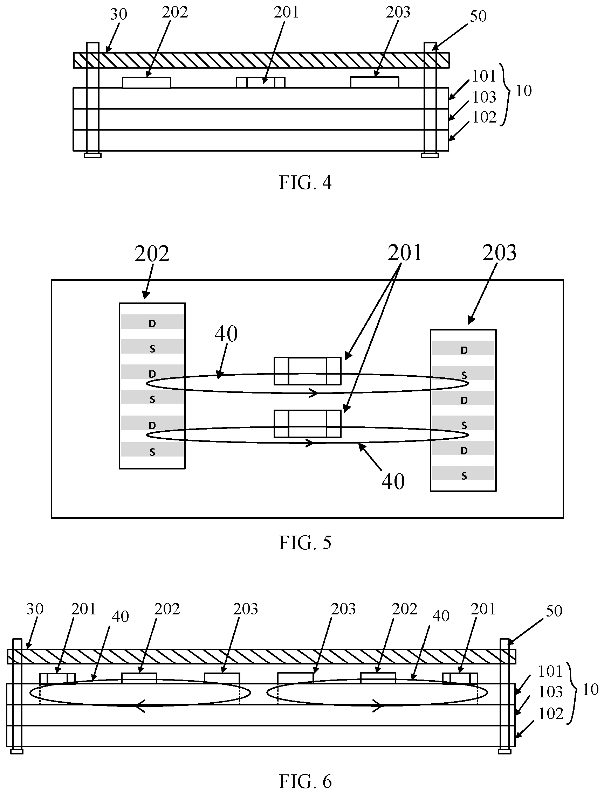

In a corresponding embodiment, a schematic cross-sectional view of the power module is shown in FIG. 4, and a difference from the foregoing embodiment may lie in that a commutation loop formed by electrically connecting the first switch unit 202, the second switch unit 203, and the first capacitor unit 201 is located on the upper surface layer 101 (not shown in FIG. 4). One terminal of the first capacitor unit 201 may reach one source of the first switch unit 202 through one drain of the first switch unit 202, reach one drain of the second switch unit 203 through metal wiring, reach one source of the second switch unit 203 through one drain of the second switch unit 203, and reach the other terminal of the first capacitor unit 201 through metal wiring.

A schematic top view of the power module is shown in FIG. 5, and the first capacitor unit may include two capacitors, which form two commutation loops 40 with the first switch unit 202 and the second switch unit 203, respectively. The electrical connection among the first switch unit 202, the second switch unit 203, and the first capacitor unit 201 may be located on the upper surface layer 101, the first switch unit 202 may be connected to the first capacitor unit 201 through metal wiring, and the second switch unit 203 may be connected to the first capacitor unit 201 through metal wiring.

Specifically, one commutation loop 40 may start from a terminal of a capacitor to a source of the first switch unit 202 through a drain of the first switch unit 202, reach a drain of the second switch unit 203 through metal wiring, and reach a source of the second switch unit 203 through a drain of the second switch unit 203, and the source of the second switch unit 203 may reach the other terminal of the capacitor through metal wiring. A connection of the other commutation loop may be the same and not be repeated.

It should be noted that, in some embodiments, the power module may include two or more switch circuits.

FIG. 6 is a schematic cross-sectional view of a power module in a fourth embodiment of the present invention. Referring to FIG. 6, the power module may include two switch circuits closely arranged along a same straight line, current directions of two commutation loops corresponding to the two switch circuits may be opposite, and both the two corresponding commutation loops may pass through the upper surface layer 101. One switch circuit may include a first capacitor unit 201, a first switch unit 202, and a second switch unit 203 arranged along a straight line, the other switch circuit may include a second switch unit 203, a first switch unit 202, and a first capacitor unit 201 arranged along the same straight line, and the similarities with the other embodiments may not be repeated.

Since directions of magnetic fields of the two commutation loops are opposite, the magnetic fields of the two commutation loops can be partially cancelled, which is more conducive to solving the problem of EMI.

When the two commutation loops 40 are not commonly grounded, copper clad planes on the inner layer 103 immediately adjacent to the upper surface layer 101 may be two separate ground planes.

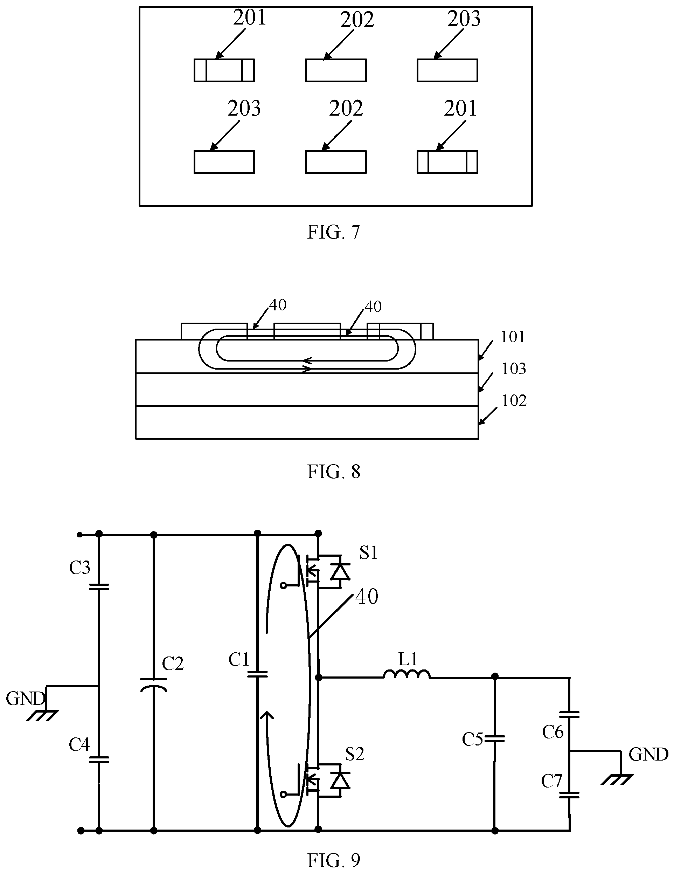

In some other embodiments, referring to FIG. 7 and FIG. 8, the two switch circuits may be arranged side by side, the current directions of the commutation loops 40 corresponding to the two switch circuits may be opposite, and both the two corresponding commutation loops 40 may pass through the upper surface layer 101. One switch circuit may include a first capacitor unit 201, a first switch unit 202, and a second switch unit 203 that are sequentially arranged along a straight line, and a magnetic field generated by a commutation loop 40 formed by the switch circuit may be inward in the commutation loop; and the other switch circuit may be arranged side by side with the above switch circuit, and include a second switch unit 203, a first switch unit 202, and a first capacitor unit 201 that are sequentially arranged along a straight line, and a magnetic field generated by a commutation loop 40 formed by this switch circuit may be outward in the commutation loop. Since the magnetic fields of the two commutation loops 40 have opposite directions and are arranged side by side, the magnetic fields of the two commutation loops 40 can be mostly or even completely canceled out, which is more beneficial to solve the problem of EMI than the above embodiment.

It should be noted that two or more commutation loops 40 may also be located on the upper surface layer 101, i.e., the commutation loops 40 may be parallel to the circuit board 10.

The switch circuit in the foregoing embodiments may be a part of a DC-DC conversion circuit such as a buck type, a boost type, a buck-boost type, or a dual active bridge resonance type, or may be a part of a DC-AC conversion circuit.

The power module in an embodiment of the present invention may be applied to a DC-DC converter, and FIG. 9 is a schematic topology diagram of a main circuit of the DC-DC converter in an embodiment of the present invention. Referring to FIG. 9, a buck topology may be used as an example, including switch transistors S1 and S2, capacitors C1, C2, C3, C4, C5, C6, and C7, and an inductor L1. The switch transistors S1, S2 and the capacitor C1 may be connected to form a switch circuit. The capacitor C2 and the capacitor C1 may be connected in parallel at an input port of the DC-DC converter. The capacitor C5 may be connected in parallel at an output port of the DC-DC converter, and the inductor L1 and the capacitor C5 may be connected in series and then connected in parallel to the switch transistor S2. The capacitor C3 may be connected between a positive input terminal of the DC-DC converter and the ground, and the capacitor C4 may be connected between a negative input terminal of the DC-DC converter and the ground. The capacitor C6 may be connected between a positive output terminal of the DC-DC converter and the ground, and the capacitor C7 may be connected between a negative output terminal of the DC-DC converter and the ground.

The capacitor C2 is configured to reduce an input voltage ripple, the capacitors C3 and C4 are configured to filter out common mode noise between the input port of the DC-DC converter and the ground, and the capacitors C6 and C7 are configured to filter out common mode noise between the output port of the DC-DC converter and the ground.

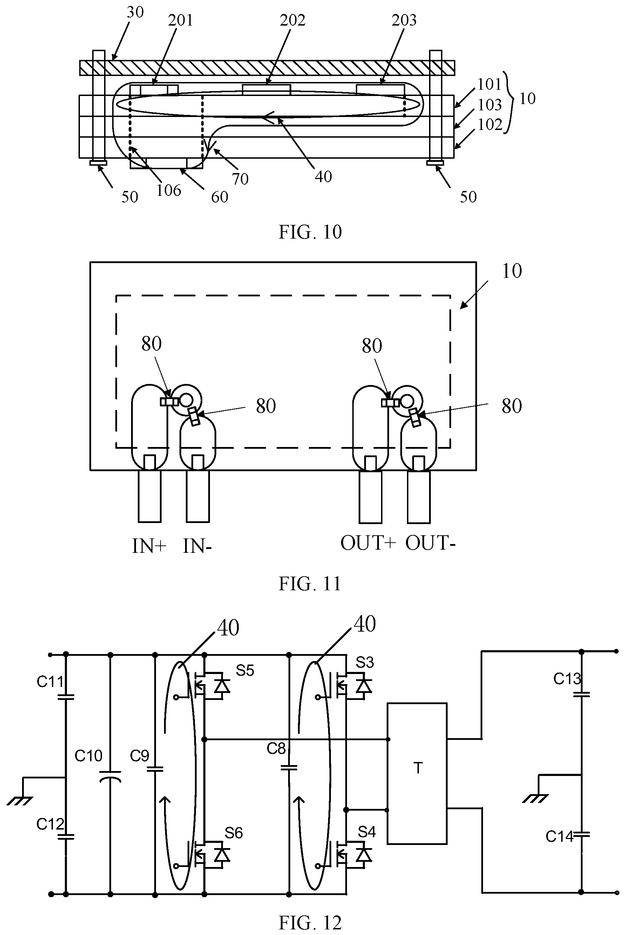

During actual application, in an embodiment, the power module may further include a third capacitor unit 60 (corresponding to the capacitor C2 in FIG. 9) disposed on the upper surface layer or the lower surface layer of the circuit board 10 and connected in parallel to the first capacitor unit 201. The third capacitor unit 60 may include at least one large-capacity capacitor, referring to FIG. 10, the third capacitor unit 60 may be connected to the first capacitor unit 201 through either or both of metal wiring on the upper surface layer 101 and a third through hole 106 penetrating through the circuit board 10, and a capacitance of the third capacitor unit 60 may be greater than that of the first capacitor unit 201. Since the commutation loop 40 formed by the first capacitor unit 201, the first switch unit 202, and the second switch unit 203 is much smaller than a commutation loop 70 formed by the third capacitor unit 60, the first switch unit 202, and the second switch unit 203, the current passing through the third capacitor unit 60 may be much smaller than that of the first capacitor unit 201.

Furthermore, in an embodiment, referring to FIG. 11, the power module may further include a plurality of second capacitor units 80 disposed on the lower surface layer 102 of the circuit board 10, and alternatively, the second capacitor units 80 may also be disposed on the upper surface layer 101 of the circuit board 10. It is taken as example that the power module includes one switch circuit, correspondingly, the power module may further include an input port (e.g., corresponding to the input port of the DC-DC converter) and an output port (e.g., corresponding to the output port of the DC-DC converter), the input port may include a positive input terminal IN+ and a negative input terminal IN-, and the output port may include a positive output terminal OUT+ and a negative output terminal OUT-. The positive input terminal IN+, the negative input terminal IN-, the positive output terminal OUT+, and the negative output terminal OUT-may be electrically connected to the metal plate 30 via corresponding second capacitor units 80 (corresponding to the capacitors C3, C4, C6, and C7 in FIG. 9, respectively), and the metal plate 30 may be taken as a virtual ground, to provide a return path for a high-frequency common mode current, so as to reduce high-frequency radiation from a cable passing through the input port and the output port, thereby meeting a radio frequency requirement.

A terminal of the second capacitor unit 80 may be electrically connected to a corresponding terminal, and the other terminal of the second capacitor unit 80 may be electrically connected to a screw hole. Left and right screw holes of the power module may be electrically connected to the metal plate 30 via the metal connector 50, respectively, the metal plate 30 may not only virtually play a role of EMI filtering, but also play a role of partially shielding EMI since the metal plate 30 is placed on one side of the commutation loop.

The power module in an embodiment of the present invention may also be applied to a DC-AC converter, FIG. 12 shows a schematic topology diagram of a main circuit of the DC-AC type power converter, including switch transistors S3, S4, S5, and S6, capacitors C8, C9, C10, C11, C12, C13, and C14, and an element T. The switch transistors S3 and S4 and the capacitor C8 may be connected to form a switch circuit corresponding to a commutation loop 40. The switch elements S5 and S6 and the capacitor C9 may be connected to form another switch circuit corresponding to another commutation loop 40. The capacitor C10 and the capacitor C9 may be connected in parallel at an input port of the DC-AC converter. The capacitor C11 may be connected between a positive input terminal of the DC-AC converter and the ground, and the capacitor C12 may be connected between a negative input terminal of the DC-AC converter and the ground. The element T may be connected to intermediate nodes of two switch transistors of the two switch circuits. The capacitor C13 may be connected between the positive output terminal of the DC-AC converter and the ground, and the capacitor C14 may be connected between the negative output terminal of the DC-AC converter and the ground.

A form of the element T may be selected according to an actual topology structure, and the element T may include a transformer, an inductor, or another electrical element or an electrical element combination that provides a specific impedance. A post-stage of the element T may be connected to a rectifier circuit such as a diode rectifier bridge, a synchronous rectifier bridge, a bidirectional rectifier bridge, or a full-wave rectifier bridge.

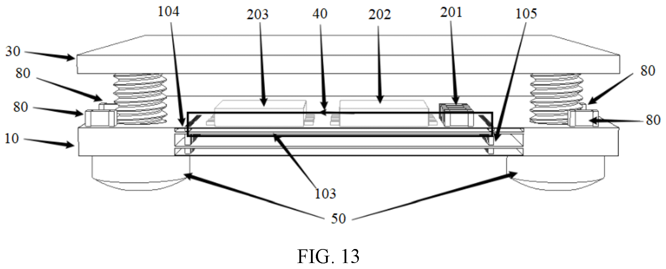

Correspondingly, FIG. 13 is a schematic cross-sectional view of a power module in an eighth embodiment of the present invention. Referring to FIG. 13, the power module may include a circuit board 10, two switch circuits, and a metal plate 30. One switch circuit may include a first switch unit 202 (corresponding to the switch transistor S3 in FIG. 12), a second switch unit 203 (corresponding to the switch transistor S4 in FIG. 12), and a first capacitor unit 201 (corresponding to the capacitor C8 in FIG. 12) that are closely arranged, and the other switch circuit may not be shown. The first switch unit 202, the second switch unit 203, and the first capacitor unit 201 may be electrically connected through the first through hole 104 and the second through hole 105 to form a commutation loop 40 passing through the upper surface layer.

The power module may further include a third capacitor unit (not shown in the figure, corresponding to the capacitor C10 in FIG. 12) disposed on the circuit board 10 and a plurality of second capacitor units 80 (corresponding to the capacitors C11, C12, C13, and C14 in FIG. 12, respectively) disposed on the upper surface layer 101 of the circuit board 10. The plurality of second capacitor units 80 may be connected to the metal plate 30 by the metal connector 50 at the input terminal and the output terminal of the power module, respectively. Specifically, one terminal of the second capacitor unit 80 may be electrically connected to an input terminal or an output terminal, and the other terminal may be electrically connected to the metal connector 50.

A power device is provided in an embodiment of the present invention, including the power module in the foregoing embodiments.

In an embodiment, the power device may further include a plastic housing, and the power module is located in the plastic housing.

In an embodiment, the power device may include a power optimizer or an inverter.

Since the power device include the power module in the above embodiments, the same technical problem can be solved and the same technical effect can be achieved, which may not be repeated here.

The various technical features of the above embodiments can be combined in any way. To make the description concise, not all possible combinations of the various technical features in the above embodiments have been described. However, as long as there is no contradiction in the combinations of these technical features, the combinations should be considered within the scope of the specification.

The above-described embodiments express only several embodiments of the present invention, which are described in a more specific and detailed manner, but are not to be construed as a limitation on the scope of the present invention. For the skill in the art, several deformations and improvements can be made without departing from the conception of the present invention, all of which fall within the scope of protection of the present invention. Therefore, the scope of protection of the present invention shall be subject to the attached claims.

## Claims

1. A power module, **characterized by** comprising a circuit board, at least one switch circuit, and a metal plate, wherein
the circuit board comprises an upper surface layer and a lower surface layer;
the at least one switch circuit is arranged on the upper surface layer of the circuit board, the at least one switch circuit comprises a first switch unit, a second switch unit, and a first capacitor unit, and the first switch unit, the second switch unit, and the first capacitor unit are electrically connected to form a commutation loop which is located on the upper surface layer of the circuit board or passes through the upper surface layer of the circuit board; and
the metal plate is arranged above the first switch unit, the second switch unit, and the first capacitor unit.

2. The power module of claim 1, wherein the first capacitor unit is disposed on a same side of the first switch unit and the second switch unit, or disposed between the first switch unit and the second switch unit.

3. The power module of claim 2, wherein the circuit board further comprises at least one inner layer between the upper surface layer of the circuit board and the lower surface layer of the circuit board, a first through hole and a second through hole are defined on the upper surface layer of the circuit board, and both the first through hole and the second through hole extend to and are electrically connected to the at least one inner layer of the circuit board;
the first through hole and the second through hole are electrically connected to the first capacitor unit and the second switch unit, respectively, a first electrical connection path between the first switch unit and the first capacitor unit and between the first switch unit and the second switch unit is disposed on the upper surface layer of the circuit board, and a second electrical connection path between the first capacitor unit and the second switch unit passes through the first through hole, the at least one inner layer of the circuit board, and the second through hole; or
the first through hole and the second through hole are electrically connected to the first switch unit and the second switch unit, respectively, a first electrical connection path between the first capacitor unit and the first switch unit and between the first capacitor unit and the second switch unit is disposed on the upper surface layer of the circuit board, and a second electrical connection path between the first switch unit and the second switch unit passes through the first through hole, the at least one inner layer of the circuit board, and the second through hole; and
the commutation loop is defined by the first electrical connection path and the second electrical connection path.

4. The power module according to claim 3, wherein the second electrical connection path is located directly below the first electrical connection path.

5. The power module of claim 3, wherein the second electrical connection path passes through one of the at least one inner layer of the circuit board closest to the upper surface layer of the circuit board.

6. The power module of claim 3, wherein a metal layer is laid on an upper surface of one of the at least one inner layer of the circuit board closest to the upper surface layer of the circuit board at positions corresponding to the first switch unit, the second switch unit, and the first capacitor unit.

7. The power module of claim 1, comprising two switch circuits, wherein the two switch circuits are arranged side by side or along a straight line, and current directions of commutation loops corresponding to the two switch circuits are opposite.

8. The power module of claim 1, further comprising a plurality of second capacitor units disposed on the circuit board, wherein an input port and an output port of the power module are electrically connected to the metal plate via corresponding second capacitor units, respectively, and the metal plate serves as a virtual ground.

9. The power module of claim 1 or claim 8, wherein the metal plate is fixedly connected to the circuit board through at least one metal connector.

10. The power module of claim 1, wherein the switch circuit further comprises a third capacitor unit disposed on the upper surface layer or the lower surface layer of the circuit board and connected in parallel to the first capacitor unit, the third capacitor unit is connected to the first capacitor unit through either or both of metal wiring of the upper surface layer and a third through hole penetrating through the circuit board, and a capacitance value of the third capacitor unit is greater than that of the first capacitor unit.

11. The power module of claim 1, wherein each of the first switch unit and the second switch unit comprises at least one switch transistor.

12. The power module of claim 1, wherein the first capacitor unit comprises at least one capacitor.

13. The power module of claim 1, wherein an electrically insulating and thermally conductive medium is filled between the circuit board and the metal plate.

14. The power module of claim 1, wherein the switching circuit is a part of a Direct Current-Direct Current converter or a Direct Current-Alternating Current converter.

15. A power device, **characterized by** comprising the power module of any one of claims 1 to 14.

16. The power device of claim 15, further comprising a plastic housing within which the power module is located.

17. The power device of claim 15, wherein the power device comprises a power optimizer or an inverter.
